(19) **Europäisches Patentamt** **European Patent Office** **Office européen des brevets**

(11) **EP 4 585 954 A1**

(12) **EUROPEAN PATENT APPLICATION**

(43) Date of publication:
**16.07.2025 Bulletin 2025/29**

(21) Application number: **24151855.4**

(22) Date of filing: **15.01.2024**

(51) International Patent Classification (IPC):
*G01R 33/56* (2006.01)  *G01R 33/561* (2006.01)

(52) Cooperative Patent Classification (CPC):
**G01R 33/5608; G01R 33/5611**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventor: **Nickel, Marcel Dominik**
**91074 Herzogenaurach (DE)**

(74) Representative: **Siemens Healthineers**
**Patent Attorneys**
**Postfach 22 16 34**
**80506 München (DE)**

(54) **IMAGE RECONSTRUCTION IN PARALLEL MR IMAGING**

(57) For image reconstruction in parallel MR imaging, a respective set of regularly undersampled MR measurement data in k-space representing an imaged object (6) is received for each of a plurality of coil channels. For each pair of coil channels of the plurality of coil channels, a respective set of reconstruction weights for reconstructing MR data at k-space points, which are not measured according to the undersampling, from the MR measurement data, is received. For each of the plurality of coil channels, a respective coil sensitivity map is determined depending on the respective sets of reconstruction weights for the respective coil channel. A reconstructed MR image is generated based on the coil sensitivity maps.

FIG 1

EP 4 585 954 A1

**Description**

The present invention is directed to a computer implemented method for image reconstruction in parallel magnetic resonance, MR, imaging, wherein a respective set of regularly undersampled MR measurement data in k-space representing an imaged object is received for each of a plurality of coil channels. The invention is further directed to a computer implemented training method for training a machine learning model, MLM, for image enhancement for use in implementations of said computer implemented method for image reconstruction. The invention is also directed to a data processing apparatus for carrying out said computer implemented methods, to a system for MRI imaging comprising said data processing apparatus and to a corresponding computer program product.

Here and in the following, the term image denotes an image in position space, also denoted as image space or image domain, unless stated otherwise. In MR imaging, image reconstruction denotes the process to generate a two-dimensional image or a three-dimensional image, typically in form of multiple two-dimensional images for multiple positions along the so-called slice direction, in position space from the MR data acquired in k-space depending on MR signals being emitted by an object to be imaged.

In general, the k-space and the position space are related to each other via Fourier transformation. When parallel MR imaging is pursued, MR data are received from multiple receiver coils, which receive the emitted MR signals. Furthermore, k-space subsampling techniques may be employed, where the k-space is sampled with a sampling rate that is too low to fulfil the Nyquist criterion. The latter is also denoted as undersampling or incomplete sampling. The multiple coils or the data provided by them, respectively, are denoted as coil channels. The reconstructed MR image can therefore not be obtained solely by Fourier transforming the acquired k-space data. Rather, more sophisticated reconstruction techniques need to be used. Various methods for MR image reconstruction are known, which may for example involve iterative processes and/or optimizations based on physical relations.

Furthermore, trained machine learning models, MLMs, for example artificial neural networks, ANNs, in particular deep convolutional neural networks, CNNs, may be used for the MR image reconstruction, for example in combination with conventional reconstruction approaches. Therein, "conventional" refers to the fact that no MLM is involved. Such methods are sometimes called deep learning, DL, reconstructions. A review of the topic is presented in the publication G. Zeng et al.: "A review on deep learning MRI reconstruction without fully sampled k-space." BMC Med Imaging 21, 195 (2021).

U-Net, introduced in the publication of O. Ronneberger et al.: "U-Net: Convolutional Networks for Biomedical Image Segmentation" (arXiv:1505.04597v1), is a well-known CNN usable for example for image segmentation or image enhancement.

One approach to train MLMs, in particular ANNs, is supervised training. Therein, training data, for example training MR images in the present context, and corresponding ground truth data, for example a reconstructed MR image in the present context, are provided. The training data is fed to the MLM, which outputs a prediction, which is then compared to the ground truth data by evaluating a loss function. The loss function may be minimized to train the MLM.

GRAPPA is a parallel imaging technique making use of phase undersampling, which results in aliased signals that need to be untangled. In GRAPPA, this correction is made in k-space before Fourier transformation into position space. GRAPPA is described in the publication M. A. Griswold et al.: "Generalized Autocalibrating Partially Parallel Acquisitions (GRAPPA)", Magn Reson Med. 2002, 47:1202-1210.

CAIPIRINHA is a parallel imaging technique using group unique k-space sampling patterns. In this way, pixel aliasing and overlap may be avoided. The points measured in k-space are shifted by applying offsets to the phase-encoding gradients. CAIPIRINHA is described for example in F. A. Breuer et al.: "Controlled Aliasing in Volumetric Parallel Imaging (2D CAIPIRINHA)", Magn Reson Med. 2006, 55:549-556. In a sense, GRAPPA can also be considered as a special case of CAIPIRINHA.

In GRAPPA or CAIPIRINHA, so-called reconstruction weights are used, which relate k-space points, which are not measured according to the undersampling, from the MR measurement data. The reconstruction weights may for example be obtained from fully sampled k-space portions, in particular around the k-space center, during or before the actual data acquisition, as described for example in the publication F. A. Breuer et al.: "General Formulation for Quantitative G-factor Calculation in GRAPPA Reconstructions", Magn Reson Med. 2009, 62:739-746.

A. Deshmane et al.: "Parallel MR imaging." J Magn Reson Imaging 2012, 36(1):55-72 is a review of parallel imaging, wherein, in particular, aliasing is explained. SENSE based models are described in the publications K.P. Pruessmann et al.: "SENSE: sensitivity encoding for fast MRI.", Magn Reson Med. 1999 Nov, 42(5):952-62, K.P. Pruessmann et al.: "Advances in Sensitivity Encoding With Arbitrary k-Space Trajectories", Magn Reson Med. 2001, 46:638-651, and M. Uecker et al.: "ESPIRiT - an eigenvalue approach to autocalibrating parallel MRI: where SENSE meets GRAPPA.", Magn Reson Med. 2014 Mar, 71(3):990-1001. In SENSE, the correction of aliasing is carried out in position space after Fourier transformation from k-space.

Compared to SENSE, k-space based methods such as GRAPPA or CAIPIRINHA often show better performance regarding said aliasing artifacts. On the other hand, in contrast to k-space based methods such as GRAPPA or CAIPIRINHA, reconstructions based on MLMs are normally used for regular undersampling schemes and the MLMs are used normally in position space.

It is an objective of the present invention, to increase the performance of aliasing correction in position space for parallel MR imaging with regular undersampling.

This objective is achieved by the subject matter of the independent claims. Further implementations and preferred embodiments are subject matter of the dependent claims.

The invention is based on the idea to use reconstruction weights to generate effective coil sensitivity maps and use them for the reconstruction in position space.

According to an aspect of the invention, a computer implemented method for image reconstruction in parallel MR imaging, in particular multi-coil parallel MR imaging, is provided. Therein, a respective set of regularly undersampled MR measurement data in k-space representing an imaged object is received for each of a plurality of coil channels. For each pair of coil channels of the plurality of coil channels, a respective set of reconstruction weights for reconstructing MR data at k-space points, which are not measured according to the undersampling, from the MR measurement data, is received. For each of the plurality of coil channels, a respective coil sensitivity map, which may also be denoted as effective coil sensitivity map, is determined depending on the respective sets of reconstruction weights for the respective coil channel. A reconstructed MR image is generated based on the coil sensitivity maps determined for the plurality of coil channels.

Unless stated otherwise, all steps of the computer implemented method may be performed by a data processing apparatus, which comprises at least one computing unit. In particular, the at least one computing unit is configured or adapted to perform the steps of the computer implemented method. For this purpose, the at least one computing unit may for example store a computer program comprising instructions which, when executed by the at least one computing unit, cause the at least one computing unit to execute the computer implemented method.

The MR measurement data are given in k-space. The data acquisition is carried out with incomplete sampling of the k-space, also denoted as undersampling. The k-space sampling scheme, in particular undersampling scheme, is a regular undersampling scheme.

An undersampled MR data acquisition is an acquisition, whose k-space sampling scheme does not fulfil the Nyquist criterion. The k-space sampling scheme may for example be defined by a discrete function $p(k)$, wherein k denotes coordinates, for example three-dimensional or two-dimensional coordinates, in k-space and $p(k)$ is non-zero, for example equal to one, only at coordinates in k-space, which shall be sampled or, in other words, measured, and equal to zero otherwise.

Regular undersampling is for example achieved by sampling only every R-th row of k-space positions along a certain sampling direction, wherein $R > 1$ is denoted as acceleration factor or reduction factor. An irregular undersampling scheme, also denoted as incoherent undersampling scheme, may for example be understood as an undersampling scheme, where the sampled k-space positions are not defined in a regular manner. For undersampling in two dimensions, exemplary sampling patterns are outlined in the publication F. A. Breuer et al.: "Controlled Aliasing ..." mentioned above.

More generally a regular undersampling has the property that the Fourier transformation of the sampling patterns in all dimensions only non-vanishing coefficients for few indicies, typically related to the acceleration factor R.

The data acquisition is carried out as parallel or multi-coil acquisition, wherein the MR data are received from multiple receiver coils, which receive the MR signals emitted from the object to be imaged. In parallel imaging, the acquired multi-coil data may be related to the reconstructed images through a signal model, which depends on respective coil sensitivity maps of the multiple coil channels.

For a given k-space position q, a set of reconstruction weights is for example given by $w_{IJ}(q)$, wherein I and J denote the coil channels of the respective pair of coil channels. Denoting the total number of coil channels by $N_C$, the total number of reconstruction weights for a given q is $N_C^2$.

In known Compressed Sensing approaches, in particular SENSE based Compressed Sensing approaches, the coil sensitivities are for example estimated based on reference data, but independent of the actually employed undersampling. This is done to have a generic solution for Compressed Sensing with arbitrary sampling patterns. But the coil sensitivities are not optimized to a given sampling pattern, which reduces the effectivity of aliasing reduction. The same holds for reconstructions using an MLM, which are for example SENSE based as well.

By means of the present invention, the reconstruction allows for the same aliasing reduction performance as a corresponding reconstruction with an aliasing correction in k-space, for example a corresponding GRAPPA or CAIPIRINHA reconstruction.

The reconstruction using the effective coil sensitivity maps as described can be done in various ways, for example according to SENSE or other algorithms using similar data consistency terms as SENSE and/or in combination with MLM based reconstructions.

According to several implementations, for each of the plurality of coil channels, the respective coil sensitivity map for a given voxel-position or pixel-position y of an aliased voxel or pixel, respectively, is determined as

$$C_I(y) = PI\left(\sum_J \chi_J^* \, W_{JI}(y)\right),$$

wherein y is an index for the voxel-position or pixel-position, I denotes the respective coil channel, J is an index running over all coil channels of the plurality of coil channels, $W_{JI}$ denotes a Fourier transform of the set of reconstruction weights for the respective pair of coil channels I, J, $\chi_J$ denotes a predefined coil combination factor for the coil channel J. The operation PI(.) denotes a grouping into sets of aliased voxels or pixels, in particular as given by $\delta_r$ and $\omega_r$ in respective implementations described further below, followed by a pseudoinverse, in particular a Moore-Penrose pseudoinverse, followed by the inverse grouping into the given order of the voxel-positions or pixel-positions.

Aliased voxels or pixels arise, in particular, as a property of the Fourier transformation when data are inserted for a regular sampling patterns and other positions are set to zero. As the result of the Fourier transformation then corresponds to a convolution with the point spread function and the Fourier transformation of the image and because the point spread function of a regular sampling pattern only has a few non-vanishing coefficients, the signal of the voxels or pixels are superimposed.

The weighting factors $\chi_J$ can be determined in different ways. In a particularly simple example, $\chi_J = 1$ for all J. The weighting factors $\chi_J$ can also depend on y as $\chi_J(y)$. The weighting factors $\chi_J$ can also be determined as approximate coil sensitivity maps, in particular pre-computed coil sensitivity maps from pre-scan normalization. In particular, in a GRAPPA reconstruction, the reconstructed coil combined MR image is given by

$$M_G(x) = \sum_I \tilde{C}_I^*(x) W_{IJ}(x) D_J(x),$$

wherein $\tilde{C}_I^*(x)$ denote the complex conjugate approximate coil sensitivity map for coil channel I and $\boldsymbol{D_J(x)}$ denote the zero-padded Fourier transformed set of MR measurement data for coil channel J. Since the $\boldsymbol{W_{IJ}(x)}$ already account for the correct undersampling scheme, the approximate coil sensitivity maps need to be less accurate and can even be set to 1 or to heuristic values obtained from previous analyses. In this example, the $\chi_J$ are given by the approximate coil sensitivity maps $\tilde{C}_I^*$. Consequently, the weighting factors $\chi_J$ are obtained in a particularly simple way.

According to several implementations, a coil channel loss term is computed for each of the plurality of coil channels depending on a Fourier transformation of the set of MR measurement data for the respective coil channel and on the coil sensitivity maps. The reconstruction comprises optimizing a first loss function, which depends on a sum of the coil channel loss terms.

The optimization of the first loss function may be carried out by using known optimization techniques, for example optimizations according to gradient-based techniques or the like. The optimization may, in particular be carried out iteratively.

Evaluating a loss function can be understood as computing a corresponding value of the loss function.

According to several implementations, the coil channel loss terms for a given voxel-position or pixel-position y of an aliased voxel or pixel, respectively, are given by

$$[1]$$

$$\left\| D_I(y) - \sum_r \omega_r \, C_I(y + \delta_r) \, M(y + \delta_r) \right\|^2,$$

wherein I denotes the respective coil channel, $D_I$ denotes the Fourier transformation of the set of MR measurement data for the respective coil channel I, M denotes the MR image to be reconstructed, r is an integer number in the interval [0, R[, wherein R is a predefined acceleration factor according to the undersampling, $\delta_r$ denotes a respective offset according to the undersampling, $\omega_r$ denotes a superposition weight according to the undersampling. $\omega_r$ may be equal to 1 in some implementations.

Consequently, the coil channel loss terms are constructed as data consistency terms as in SENSE. This allows the invention to be applied to any reconstruction methods that make use of such data consistency terms. The information regarding the undersampling scheme is fully contained in the effective coil sensitivity maps via the reconstruction weights. The advantages of SENSE based reconstructions and the performance of reconstruction with k-space aliasing correction, such as GRAPPA or CAIPIRINHA, are therefore combined.

According to several implementations, the set of reconstruction weights is determined as a set of GRAPPA reconstruction weights or as a set of CAIPIRINHA reconstruction weights.

The set of reconstruction weights may for example be determined as described in the above mentioned publication of F. A. Breuer et al.: "General Formulation [...]".

In particular, the acquisition scheme for generating the MR measurement data may involve a full sampling of a sub-region of the sampled k-space, in particular around the k-space center. The GRAPPA or CAIPIRINHA reconstruction weights may be determined based on the data obtained for the fully sampled sub-region.

Alternatively, the set of reconstruction weights may be determined depending on pre-scan MR measurement data corresponding to a fully sampled k-space region. The pre-scan MR measurement data are then acquired during pre-scan runs before the MR measurement data are acquired.

According to several implementations the reconstruction for generating the reconstructed MR image comprises carrying out at least two iterations, at least two iterations including an initial iteration and a final iteration. For each iteration of at least two iterations,

a) a prior MR image for the respective iteration is received, and

b) an optimized MR image is generated by optimizing the first loss function based on the prior MR image.

c) An enhanced MR image is generated by applying a trained MLM for image enhancement to the optimized MR image. Therein,

d) unless the respective iteration corresponds to the initial iteration, the prior MR image of the respective iteration corresponds to the enhanced MR image of a preceding iteration of the at least two iterations, in particular an iteration directly preceding the current iteration. The prior MR image of the initial iteration corresponds to a predefined initial image. The reconstructed MR image corresponds to the enhanced MR image of the final iteration.

In particular, the first loss function depends on the sum of the coil channel loss terms and also depends on the prior MR image of the respective iteration.

The optimization of the first loss function in step b) may, in particular be carried out iteratively itself. In this case, the at least two iterations may be considered as outer iterations, while the optimization may comprise inner iterations.

The initial image may for example be a guess for the reconstructed MR image or it may also be an image with constant pixel values everywhere, for example zero. Each iteration provides the enhanced MR image as another preliminary candidate for the reconstructed MR image, thus iteratively achieving an increased quality of the eventual reconstructed MR image as the enhanced MR image of the final iteration.

The total number of the at least two iterations is not necessarily very large, it can for example lie in the range of 2 to 20 iterations or 2 to 10 iterations or 3 to 7 iterations. Thus, the computational effort is limited.

The MLM is an MLM for image enhancement, for example an ANN. In other words, an input to the MLM is an image, in the present case the optimized MR image, and an output of the MLM is an image as well, in the present case the enhanced MR image. Therein, the output image is enhanced with respect to the input image. What exactly is the effect of the enhancement depends on the training MR images and the ground truth used for training the MLM. For example, the training MR images may be intentionally corrupted or deteriorated using for example blurring filters, adding noise, and so forth. By means of the training, the MLM learns to enhance an input image accordingly.

For example, in case the MLM is an ANN, it may be a U-Net, as described in the publication of O. Ronneberger et al mentioned in the introductory part of the present disclosure, or an ANN based on the U-Net architecture.

In general terms, a trained MLM may mimic cognitive functions that humans associate with other human minds. In particular, by training based on training data the MLM may be able to adapt to new circumstances and to detect and extrapolate patterns. Another term for a trained MLM is "trained function".

In general, parameters of an MLM can be adapted by means of training. In particular, supervised training, semi-supervised training, unsupervised training, reinforcement learning and/or active learning can be used. Furthermore, representation learning, also denoted as feature learning, can be used. In particular, the parameters of the MLMs can be adapted iteratively by several steps of training. In particular, within the training a certain loss function, also denoted as cost function, can be minimized. In particular, within the training of an ANN, the backpropagation algorithm can be used.

In particular, an MLM can comprise an ANN, a support vector machine, a decision tree and/or a Bayesian network, and/or the machine learning model can be based on k-means clustering, Q-learning, genetic algorithms and/or association rules. In particular, an ANN can be or comprise a deep neural network, a convolutional neural network or a convolutional deep neural network. Furthermore, an ANN can be an adversarial network, a deep adversarial network and/or a generative adversarial network.

According to several implementations, the MLM is an ANN, for example a CNN.

According to several implementations, the optimization of the first loss function is carried out under variation of a variable MR image, while the prior MR image is kept constant during the optimization, in particular of a given iteration.

The variable MR image can be understood as the respective optimization variables of the optimization in step b). As a result of the optimization, the optimal variable MR image corresponds to the optimized MR image.

For example, the variable MR image corresponds to $M(y + \delta_r)$ in equation [1] above.

The first loss function may also comprise a regularization term, which depends on the prior MR image and the variable MR image of the respective iteration.

The regularization term may for example be given by a Tikhonov regularization term. The first loss function, in particular, comprises or consists of the sum of the coil channel loss terms and the regularization term.

The regularization term may quantify a deviation between the prior MR image of the respective iteration and the variable MR image. The regularization term may for example depend on the L1-norm of the difference between the prior MR image of the respective iteration and the variable MR image. For example, the regularization term may be given by

$$\frac{1}{\lambda_n} \|M(y) - M_n(y)\|^2,$$

wherein n denotes the respective iteration, $M_n(y)$ denotes the prior MR image of the respective iteration, and $\lambda_n$ denotes a regularization weight. The regularization weight may be the same for all of the at least two iterations or it may be different for different iterations.

According to a further aspect of the invention, a method for MR image reconstruction is provided. Therein, the respective set of regularly undersampled MR measurement data in k-space representing the imaged object is generated for each of the plurality of coil channels by an MRI scanner and a computer implemented method for image reconstruction according to the invention is carried out.

According to a further aspect of the invention, a computer implemented training method for training an MLM for image enhancement for use in an implementation of the computer implemented method for image reconstruction according to the invention, wherein the reconstruction comprises said steps a), b), c) and d) and the reconstructed MR image corresponds to the enhanced MR image of a final iteration of the at least two iterations.

In the computer implemented training method, training MR data is received and a ground truth reconstructed MR image corresponding to the training MR data is received. At least two training iterations including an initial training iteration and a final training iteration are carried out.

For each training iteration of the at least two training iterations,

a') a training prior MR image for the respective training iteration is received, and
b') an optimized training MR image is generated by optimizing a predefined second loss function based on the training MR data and the training prior MR image.
c') an enhanced training MR image is generated by applying the MLM to the optimized training MR image. Therein,
d') unless the respective training iteration corresponds to the initial training iteration, the training prior MR image of the respective training iteration corresponds to the enhanced training MR image of a preceding training iteration. The training prior MR image of the initial training iteration corresponds to a predefined initial training image.

A predefined third loss function is evaluated depending on the enhanced MR image of the final training iteration of the at least two training iterations and the ground truth reconstructed MR image. Parameters of the MLM are updated depending on a result of the evaluation of the third loss function.

As mentioned above, the output image of MLM is enhanced with respect to its input image. What exactly is the effect of the enhancement depends on the training MR measurement data and the ground truth reconstructed MR image. For example, the training MR data may be intentionally corrupted or deteriorated using for example blurring filters, adding noise, and so forth. By means of the training, the MLM learns to enhance an input image accordingly.

The input to the MLM, for example the ANN, is the optimized MR image of the respective training iteration and its output is the enhanced MR image. However, the evaluation of the third loss function is not carried out for each iteration but only after all of the two or more iterations have been carried out. Thus, also the optimization of the step b') is included in the training process, which leads to an increased training efficiency.

The MLM may for example be an ANN, in particular a CNN, for example a U-Net or an architecture based on the U-Net. In this case, updating the MLM can be understood as updating network parameters, in particular network weights and/or bias factors, of the ANN. The updating may be done by using known algorithms, such as backpropagation.

The third loss function may also be a known loss function used for training image enhancement ANNs, such as for example a pixel-wise loss function, for example an L1-loss function or an L2-loss function.

The described steps including the at least two iterations, the evaluation of the third loss function, and the update of the MLM are, in particular, understood as a single training run. A plurality of such runs may be carried out consecutively, until a predetermined termination or convergence criterion regarding the second loss function is reached. Each set of at least one training image may be denoted as a training sample. The number of training samples may lie in the order of 10000 or several times 10000. The number of training epochs may for example lie in the order 100-1000. The total number of training runs is for example given by the product of the number of training samples and the number of training epochs.

According to several implementations, the ground truth reconstructed MR image is generated assuming full k-space sampling.

According to several implementations, the optimization of the second loss function is carried out under variation of a variable MR image, while the training prior MR image is kept constant during the optimization. The second loss function comprises for example a data consistency term as described for the first loss function.

According to several implementations, the second loss function comprises a regularization term, which depends on the training prior MR image and the variable MR image.

In particular, the second loss function may be identical to the first loss function in some implementations. This is, however, not necessarily the case. The second loss function may also be a known loss function for SENSE approaches or the like.

According to several implementations of the computer implemented method for MR image reconstruction, the MLM is trained or has been trained by using a computer implemented training method according to the invention.

The computer implemented method for image reconstruction may, in some implementations, comprise training the MLM by using a computer implemented training method according to the invention. In other implementations, the computer implemented method for MR image reconstruction does not include the steps of the computer implemented training method.

According to a further aspect of the invention, a data processing apparatus comprising at least one computing unit is provided. The at least one computing unit is adapted to carry out a computer implemented training method according to the invention and/or a computer implemented method for image reconstruction according to the invention.

A computing unit may in particular be understood as a data processing device, which comprises processing circuitry. The computing unit can therefore in particular process data to perform computing operations. This may also include operations to perform indexed accesses to a data structure, for example a look-up table, LUT.

In particular, the computing unit may include one or more computers, one or more microcontrollers, and/or one or more integrated circuits, for example, one or more applicationspecific integrated circuits, ASIC, one or more fieldprogrammable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, a system for MR imaging is provided. The system comprises a data processing apparatus according to the invention, wherein the at least one computing unit is adapted carry out a computer implemented method for MR image reconstruction according to the invention. The system comprises an MRI scanner. The at least one computing unit is adapted to control the MRI scanner to generate the at least two measured MR images.

According to a further aspect of the invention, a first computer program comprising first instructions is provided. When the first instructions are executed by a data processing apparatus, the first instructions cause the data processing apparatus to carry out a computer implemented training method according to the invention.

The first instructions may be provided as program code, for example. The program code can for example be provided as binary code or assembler and/or as source code of a programming language, for example C, and/or as program script, for example Python.

According to a further aspect of the invention, a second computer program comprising second instructions is provided. When the second instructions are executed by a data processing apparatus, the second instructions cause the data processing apparatus to carry out a computer implemented method for image reconstruction according to the invention. The second instructions may be provided as program code, for example. The program code can for example be provided as binary code or assembler and/or as source code of a programming language, for example C, and/or as program script, for example Python.

According to a further aspect of the invention, a computer-readable storage medium, in particular a tangible and nontransient computer-readable storage medium, storing a first computer program and/or a second computer program according to the invention is provided.

The first computer program, the second computer program and the computer-readable storage medium are respective computer program products comprising the first instructions and/or the second instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

Above and in the following, the solution according to the invention is described with respect to the claimed systems as well as with respect to the claimed methods. Features, advantages or alternative embodiments herein can be assigned to the other claimed objects and vice versa. In other words, claims and embodiments for the systems can be improved with features described or claimed in the context of the respective methods. In this case, the functional features of the method are implemented by physical units of the system.

Furthermore, above and in the following, the solution according to the invention is described with respect to methods and systems for MR image reconstruction as well as with respect to methods and systems for providing a trained MLM. Features, advantages or alternative embodiments herein can be assigned to the other claimed objects and vice versa. In other words, claims and embodiments for providing a trained MLM can be improved with features described or claimed in the context of MR image reconstruction. In particular, datasets used in the methods and systems can have the same properties and features as the corresponding datasets used in the methods and systems for providing a trained MLM, and the trained MLMs provided by the respective methods and systems can be used in the methods and systems for MR image reconstruction.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1    shows a schematic block diagram of an exemplary implementation of a system for MR imaging according to the invention;

FIG 2    shows a schematic flow diagram of an exemplary implementation of a computer implemented method for image reconstruction according to the invention;

FIG 3    shows a schematic flow diagram of a further exemplary implementation of a computer implemented method for image reconstruction according to the invention;

FIG 4    shows a schematic flow diagram of an exemplary implementation of a computer implemented training method according to the invention;

FIG 5    shows a schematic representation of a convolutional neural network; and

FIG 6    shows a schematic representation of a further convolutional neural network.

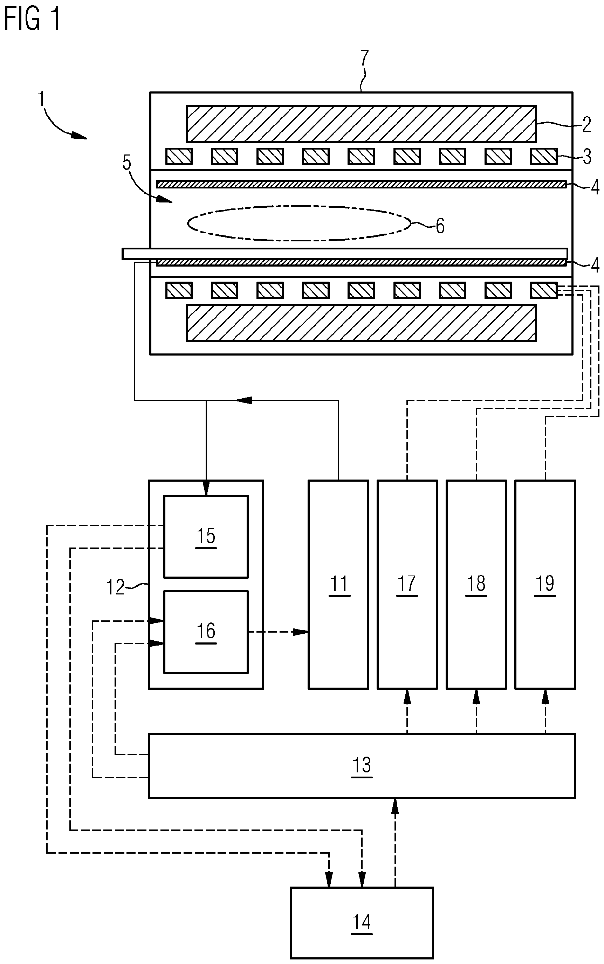

FIG 1 shows schematically an exemplary implementation of a system for MR imaging, also denoted as MRI system 1, according to the invention. The MRI system 1 comprises a housing 7 defining a bore 5 and a main magnet arrangement 2, which is configured to generate a main magnetic field, also denoted as polarizing magnetic field, within the bore 5. The MRI system 1 comprises an RF system 55, 11, 12, which is configured to apply an asymmetric RF pulse to a target material, in particular a body part of a patient 6, disposed within the bore 5 and to receive MR signals from the target material. For example, the main magnet arrangement 2 may generate a uniform main magnetic field B0 as the main magnetic field and at least one RF coil 4 of the RF system 4, 11, 12 may emit an excitation field B1. The MRI system 1 comprises a data processing apparatus with at least one computing unit 13, 14, which is configured to construct the asymmetric RF pulse by using a computer implemented method for constructing an asymmetric RF pulse according to the present disclosure.

To this end, the at least one computing unit 13, 14 determines a first RF amplitude for a predefined first part of a predefined time interval, and receives an RF amplitude curve, which depends on at least one RF curve parameter. The at least one computing unit 13, 14 determines a combined RF amplitude curve for the time interval by combining, in particular concatenating, the first RF amplitude for the first part of the time interval and the RF amplitude curve for a predefined second part of the time interval, which succeeds the first part of the time interval. The at least one computing unit 13, 14 carries out an optimization to optimize the combined RF amplitude curve using a loss function, which comprises an energy loss term, which depends on a pulse energy of the combined RF amplitude curve, and using the at least one RF curve parameter as at least one optimization variable. The at least one computing unit 13, 14 determines the asymmetric RF pulse, wherein a combined amplitude of the asymmetric RF pulse for the time interval is given by the optimized combined RF amplitude curve.

According to MR techniques, the target material is subjected to the main magnetic field, causing the nuclear spins in the target material to precess about the main magnetic field at their characteristic Larmor frequency. A net magnetic moment $M_z$ is produced in the direction z of the main magnetic field, and the randomly oriented magnetic moments of the nuclear spins cancel out one another in the x-y-plane.

When the target material is then subjected to the transmit RF magnetic field, which is for example in the x-y plane and near the Larmor frequency, the net magnetic moment rotates out of the z-direction generating a net in-plane magnetic moment, which rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 15 of an RF controller 12 of the RF system 4, 11, 12, and processed by at least one processor 14 of the at least one computing unit 13, 14 to reconstruct an MR image using for example a computer implemented method for MR image reconstruction according to the invention.

In particular, gradient coils 3 of the MRI system 1 may produce magnetic field gradients $G_x$, $G_y$, and $G_z$ for positionencoding of the MR signals. Accordingly, MR signals are emitted only by such nuclei of the target material, which correspond to the particular Larmor frequency. For example, $G_z$ is used together with a bandwidth-limited RF pulse to select a slice perpendicular to the z-direction and consequently may also be denoted as slice selection gradient. In alternative example, $G_x$, $G_y$, and $G_z$ may be used in any predefined combination with a bandwidth-limited RF pulse to select a slice perpendicular to the vector sum of said gradient combination. The gradient coils 3 may be supplied with current by respective amplifiers 17, 18, 19 for generating the respective gradient fields in x-direction, y-direction, and z-direction, respectively. Each amplifier 17, 18, 19 may include a respective digital-to-analog converter, which is controlled by the sequence controller 13 to generate respective gradient pulses at predefined time instances.

It is noted that the components of the MRI system 1 can also be arranged differently from the arrangement shown in FIG 1. For example, the gradient coils 3 may be arranged inside the bore 5, similar as shown for the at least one RF coil 4.

A sequence controller 13 of the at least one computing unit 13, 14 may control the generation of RF pulses by an emitter channel 16 of the RF controller 12 and an RF power amplifier 11 of the RF system 4, 11, 12.

The least one processor 14 may receive the real and imaginary parts from analog-digital converters of the receiver channel 15 and reconstruct the MR image based on them.

It is noted that each component of the MRI system 1 may include other elements which are required for the operation thereof, and/or additional elements for providing functions other than those described in the present disclosure.

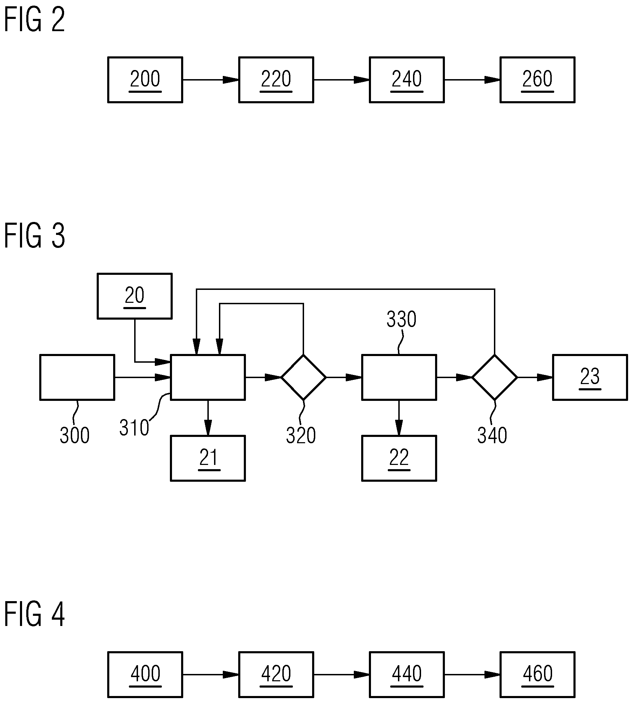

FIG 2 shows a schematic flow diagram of an exemplary implementation of a computer implemented method for image reconstruction according to the invention.

In step 200, a respective set of regularly undersampled MR measurement data in k-space representing an imaged object 6 is received for each of a plurality of coil channels, in particular from the MRI system 1. In step 220, for each pair of coil channels of the plurality of coil channels, a respective set of reconstruction weights for reconstructing MR data at k-space points, which are not measured according to the undersampling, from the MR measurement data, is received. In step 240, for each of the plurality of coil channels, a respective coil sensitivity map is determined depending on the respective sets of reconstruction weights for the respective coil channel. In step 260, a reconstructed MR image 23 is generated based on the coil sensitivity maps.

FIG 3 shows a schematic flow diagram of a further exemplary implementation of a computer implemented method for image reconstruction according to the invention.

In such implementations, a coil channel loss term is computed for each of the plurality of coil channels depending on a Fourier transformation of the set of MR measurement data for the respective coil channel and on the coil sensitivity maps. The reconstruction comprises optimizing a first loss function, which depends on a sum of the coil channel loss terms.

In step 300, the MR measurement data representing the imaged object 6 is obtained, in particular from the MRI system 1. For each iteration of at least two iterations, a prior MR image for the respective iteration is received. The prior MR image of an initial iteration of the at least two iterations is given by a predefined initial image 20. In steps 310 and 320, an optimized MR image 21 is generated by optimizing the first loss function, which depends on the MR measurement data and on the prior MR image. The optimization may be carried out iteratively as well. Step 310 then corresponds to an optimization step, while in step 320, it is determined whether a termination or convergence criterion for the optimization is reached. If this is not the case, another optimization step 310 is carried out, otherwise the optimized MR image 21 is further processed in step 330.

In step 330, an enhanced MR image 22 is generated by applying a trained MLM to the optimized MR image 21. The prior MR image of the respective iteration is given by the enhanced MR image 22 of the corresponding preceding iteration, unless the respective iteration corresponds to the initial iteration. In step 340, it is determined whether a predefined total number of the at least two iterations has been carried out. If this is not the case, the next iteration is carried out.

Otherwise, the reconstructed MR image 23 is determined as the enhanced MR image 22 of a final iteration of the at least two iterations.

In contrast to Compressed Sensing techniques, MLM based reconstructions, for example deep learning, DL, reconstructions, are for example used for conventional, regular undersampling patterns as used in known parallel imaging schemes. MLM based reconstructions may include parallel imaging models for data consistency. As for Compressed Sensing applications, these may rely on a SENSE based modelling that employs coil sensitivity maps to relate the reconstructed MR image 23 to the acquired MR measurement data. However, k-space based parallel imaging methods such as GRAPPA or CAIPIRINHA may show better performance regarding aliasing artifacts, which are also termed warp arounds or PAT artifacts.

For a predefined regular undersampling pattern, effective coil sensitivity maps can be determined as in parallel imaging approaches like GRAPPA or CAIPIRINHA. These give identical performance as the k-space based parallel imaging approaches and can be used for example in DL reconstructions. Therefore, the degree of aliasing, which is not addressed by known MLM based reconstructions and a significant drawback of known approaches as MLMs allow for higher acceleration factors, can be reduced.

As a starting point for a specific embodiment, the imagebased formulation of GRAPPA may be considered. GRAPPA first estimates GRAPPA kernels, also denoted as GRAPPA reconstruction weights, from the reference data in k-space, by finding the best fit for generating non-measured data according to

$$d_I(k) = \sum_{J,q} w_{IJ}(q) d_J(k - q),$$

where $d_I(k)$ is the set of MR measurement data for the I-th coil channel at k-space position k. Furthermore, $w_{IJ}(q)$ are the GRAPPA reconstruction weights. Non-measured k-space data are therefore determined by convolution of the MR measurement data on a regular parallel imaging sampling pattern with the GRAPPA reconstruction weights.

Since the Fourier transformation converts a convolution into a multiplication, GRAPPA can be translated into the imagedomain as the pointwise matrix multiplication. The unfolding of the images can be performed as

$$F_I(x) = \sum_{J} W_{IJ}(x) D_J(x),$$

where $F_I(x)$ is the reconstructed coil image of the coil channel I at the voxel or pixel position x. $W_{IJ}(x)$ are determined from the k-space GRAPPA reconstruction weights $w_{IJ}(q)$ by the use of Fourier transformation. Furthermore, $D_J(x)$ are the zero-padded Fourier transformed $d_J(k)$ that, in general, show aliasing according to the chosen undersampling pattern.

Since reconstructed MR images are coil-combined, GRAPPA usually employs an adaptive coil combination. Here also approximate coil sensitivities are used, but they need to be less accurate as the parallel imaging reconstruction is already performed through the GRAPPA reconstruction weights. For example, coil sensitivities from a pre-scan normalization adjustment scan may be used. Defining these approximate coil sensitivities as $\tilde{C}_I(x)$, the reconstructed coil-combined image is then given by

$$M(x) = \sum_{I} \tilde{C}_I^*(x) F_I(x) = \sum_{IJ} \tilde{C}_I^*(x) W_{IJ}(x) D_J(x) = \sum_{J} \rho_J^*(x) D_J(x).$$

Here, the unmixing weights $\tilde{\rho}_J(x)$ that are used to unfold the zero-padded coil images are implicitly.

On the other hand, SENSE is formulated in image space and the reconstructed image is determined as the minimum of the loss function

$$\sum_{y,I} \left\| D_I(y) - \sum_{r} C_I(y + \delta_r) M(y + \delta_r) \right\|^2.$$

Here, y runs over the set of aliased voxels or pixels. Thus, for an overall acceleration factor of R, y runs over N/R voxels or pixels with N being the total number of voxels or pixels. $\delta_r$ denote the offset of aliased voxels with r 6 [0,R). The solution of this optimization can be written down as

$$M(y + \delta_r) = \sum_I \alpha_I^*(y + \delta_r)D_I(y),$$

where in this case $\alpha_I^*(y + \delta_r)$ is the pseudoinverse in indices I and r of the matrix $C_I(y + \delta_r)$ for each position y.

Consequently, one can interpret $\alpha_I^*(y + \delta_r)$ as unmixing weights and $\rho_j^*(x)$ we can determine effective GRAPPA coil sensitivities as the pseudoinverse of the unmixing weights in the indices I and r.

This ensures by definition that the SENSE reconstruction gives the same result as the corresponding GRAPPA or CAIPIRINHA reconstruction. Once the effective coil sensitivities are known, they can be used in more complicated algorithms where the data consistency of the SENSE model is only one part.

The idea has been implemented based on the Siemens CAIPIRINHA reconstruction and integrated into a DL reconstruction framework. Aliasing artifacts are found to be strongly reduced. The benefit becomes even more pronounced for DL reconstructions with higher acceleration factors. It is noted that the invention does not necessarily have to be combined with MLM reconstruction. The latter is, however, particularly beneficial for MLM reconstructions using a combination of SENSE based data consistency and image regularization.

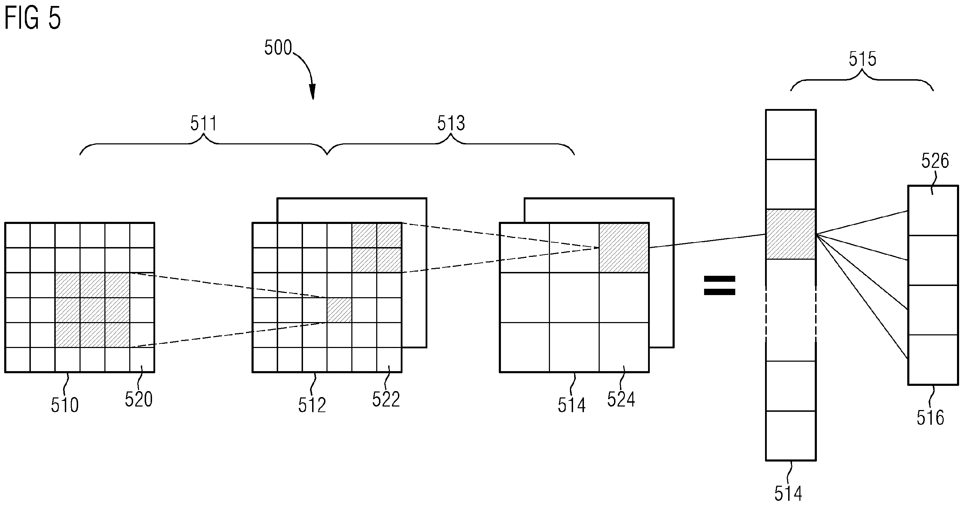

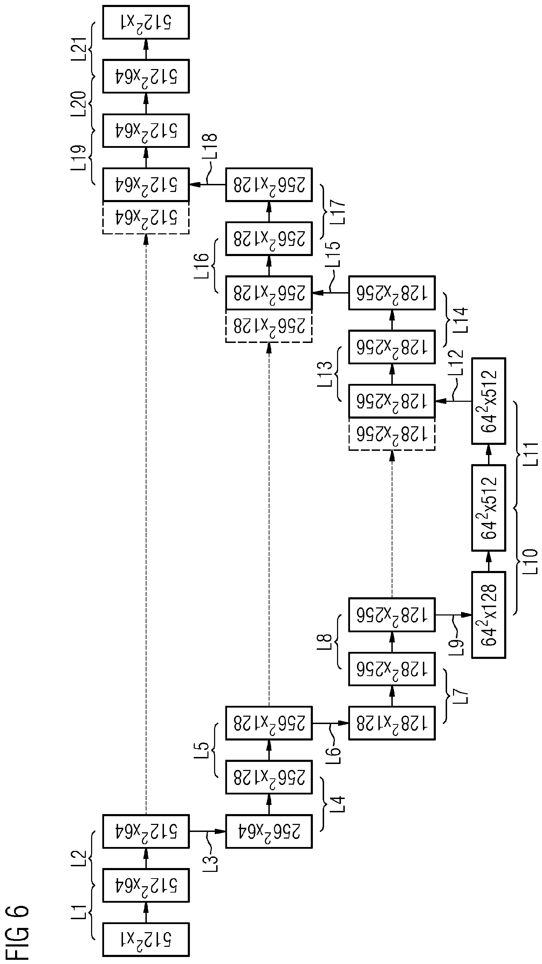

The MLM may for example be an ANN, in particular a CNN, as shown schematically in FIG 5, FIG 6.

A CNN is an ANN that uses a convolution operation instead general matrix multiplication in at least one of its layers. These layers are denoted as convolutional layers. In particular, a convolutional layer performs a dot product of one or more convolution kernels with the convolutional layer's input data, wherein the entries of the one or more convolution kernel are parameters or weights that may be adapted by training. In particular, one can use the Frobenius inner product and the ReLU activation function. A convolutional neural network can comprise additional layers, for example pooling layers, fully connected layers, and/or normalization layers.

By using convolutional neural networks, the input can be processed in a very efficient way, because a convolution operation based on different kernels can extract various image features, so that by adapting the weights of the convolution kernel the relevant image features can be found during training. Furthermore, based on the weight-sharing in the convolutional kernels less parameters need to be trained, which prevents overfitting in the training phase and allows to have faster training or more layers in the network, improving the performance of the network.

FIG 4 displays an exemplary embodiment of a convolutional neural network 500. In the displayed embodiment, the convolutional neural network 500 comprises an input node layer 510, a convolutional layer 511, a pooling layer 513, a fully connected layer 514 and an output node layer 516, as well as hidden node layers 512, 514. Alternatively, the convolutional neural network 500 can comprise several convolutional layers 511, several pooling layers 513 and/or several fully connected layers 515, as well as other types of layers. The order of the layers can be chosen arbitrarily, usually fully connected layers 515 are used as the last layers before the output layer 516.

In particular, within a convolutional neural network 500 nodes 520, 522, 524 of a node layer 510, 512, 514 can be considered to be arranged as a d-dimensional matrix or as a d-dimensional image. In particular, in the two-dimensional case the value of the node 520, 522, 524 indexed with i and j in the n-th node layer 510, 512, 514 can be denoted as x(n)[i, j]. However, the arrangement of the nodes 520, 522, 524 of one node layer 510, 512, 514 does not have an effect on the calculations executed within the convolutional neural network 500 as such, since these are given solely by the structure and the weights of the edges.

A convolutional layer 511 is a connection layer between an anterior node layer 510 with node values x(n-1) and a posterior node layer 512 with node values x(n). In particular, a convolutional layer 511 is characterized by the structure and the weights of the incoming edges forming a convolution operation based on a certain number of kernels. In particular, the structure and the weights of the edges of the convolutional layer 511 are chosen such that the values x(n) of the nodes 522 of the posterior node layer 512 are calculated as a convolution x(n) = K * x(n-1) based on the values x(n-1) of the nodes 520 anterior node layer 510, where the convolution * is defined in the two-dimensional case as

$$x^{(n)}[i, j] = \left(K * x^{(n-1)}\right)[i, j] = \sum_{i'} \sum_{j'} K[i', j'] \cdot x^{(n-1)}[i - i', j - j'].$$

Herein, the kernel K is a d-dimensional matrix, in the present example a two-dimensional matrix, which is usually small compared to the number of nodes 520, 522, for example a 3x3 matrix, or a 5x5 matrix. In particular, this implies that the weights of the edges in the convolution layer 511 are not independent, but chosen such that they produce said convolution equation. In particular, for a kernel being a 3x3 matrix, there are only 9 independent weights, each entry of the kernel matrix corresponding to one independent weight, irrespectively of the number of nodes 520, 522 in the anterior node layer 510 and the posterior node layer 512.

In general, convolutional neural networks 500 use node layers 510, 512, 514 with a plurality of channels, in particular, due to the use of a plurality of kernels in convolutional layers 511. In those cases, the node layers can be considered as (d+1)-dimensional matrices, the first dimension indexing the channels. The action of a convolutional layer 511 is then in a two-dimensional example defined as

$$x_b^{(n)}[i,j] = \sum_a (K_{a,b} * x_a^{(n-1)}[i,j] = \sum_a \sum_{i'} \sum_{j'} K_{a,b}[i',j'] \cdot x_a^{(n-1)}[i-i',j-j'],$$

wherein $x_a^{(n)}$ corresponds to the a-th channel of the anterior node layer 510, $x_b^{(n)}$ corresponds to the b-th channel of the posterior node layer 512 and $K_{a,b}$ corresponds to one of the kernels. If a convolutional layer 511 acts on an anterior node layer 510 with A channels and outputs a posterior node layer 512 with B channels, there are A·B independent d-dimensional kernels $K_{a,b}$.

In general, in convolutional neural networks 500 activation functions may be used. In this embodiment, ReLU (rectified linear unit) is used, with R(z) = max(0, z), so that the action of the convolutional layer 511 in the two-dimensional example is

$$x_b^{(n)}[i,j] = R\left(\sum_a (K_{a,b} * x_a^{(n-1)}[i,j]\right)$$

$$= R\left(\sum_a \sum_{i'} \sum_{j'} K_{a,b}[i',j'] \cdot x_a^{(n-1)}[i-i',j-j']\right).$$

It is also possible to use other activation functions, for example ELU (exponential linear unit), LeakyReLU, Sigmoid, Tanh or Softmax.

In the displayed embodiment, the input layer 510 comprises 36 nodes 520, arranged as a two-dimensional 6x6 matrix. The first hidden node layer 512 comprises 72 nodes 522, arranged as two two-dimensional 6x6 matrices, each of the two matrices being the result of a convolution of the values of the input layer with a 3x3 kernel within the convolutional layer 511. Equivalently, the nodes 522 of the first hidden node layer 512 can be interpreted as arranged as a three-dimensional 2x6x6 matrix, wherein the first dimension correspond to the channel dimension.

An advantage of using convolutional layers 511 is that spatially local correlation of the input data can exploited by enforcing a local connectivity pattern between nodes of adjacent layers, in particular by each node being connected to only a small region of the nodes of the preceding layer.

A pooling layer 513 is a connection layer between an anterior node layer 512 with node values x(n-1) and a posterior node layer 514 with node values x(n). In particular, a pooling layer 513 can be characterized by the structure and the weights of the edges and the activation function forming a pooling operation based on a non-linear pooling function f. For example, in the two-dimensional case the values x(n) of the nodes 524 of the posterior node layer 514 can be calculated based on the values x(n-1) of the nodes 522 of the anterior node layer 512 as

$$x_b^{(n)}[i,j] = f\left(x_b^{(n-1)}[id_1, jd_2], \dots, \quad x_b^{(n-1)}[(i+1)d_1-1, (j+1)d_2-1]\right).$$

In other words, by using a pooling layer 513, the number of nodes 522, 524 can be reduced by re-placing a number d1·d2 of neighboring nodes 522 in the anterior node layer 512 with a single node 522 in the posterior node layer 514 being calculated as a function of the values of said number of neighboring nodes. In particular, the pooling function f can be the max-function, the average, or the L2-Norm. In particular, for a pooling layer 513 the weights of the incoming edges are fixed and are not modified by training. The advantage of using a pooling layer 513 is that the number of nodes 522, 524 and the number of parameters is reduced. This leads to the amount of computation in the network being reduced and to a control of overfitting.

In the displayed embodiment, the pooling layer 513 is a max-pooling layer, replacing four neighboring nodes with only one node, the value being the maximum of the values of the four neighboring nodes. The max-pooling is applied to each d-dimensional matrix of the previous layer. In this embodiment, the max-pooling is applied to each of the two two-dimensional matrices, reducing the number of nodes from 72 to 18.

In general, the last layers of a convolutional neural network 500 may be fully connected layers 515. A fully connected layer 515 is a connection layer between an anterior node layer 514 and a posterior node layer 516. A fully connected layer 513 can be characterized by the fact that a majority, in particular, all edges between nodes 514 of the anterior node layer 514 and the nodes 516 of the posterior node layer are present, and wherein the weight of each of these edges can be adjusted individually.

In this embodiment, the nodes 524 of the anterior node layer 514 of the fully connected layer 515 are displayed both as two-dimensional matrices, and additionally as non-related nodes, indicated as a line of nodes, wherein the number of nodes was reduced for a better presentability. This operation is also denoted as flattening. In this embodiment, the number of nodes 526 in the posterior node layer 516 of the fully connected layer 515 smaller than the number of nodes 524 in the anterior node layer 514. Alternatively, the number of nodes 526 can be equal or larger.

Furthermore, in this embodiment the Softmax activation function is used within the fully connected layer 515. By applying the Softmax function, the sum the values of all nodes 526 of the output layer 516 is 1, and all values of all nodes 526 of the output layer 516 are real numbers between 0 and 1. In particular, if using the convolutional neural network 500 for categorizing input data, the values of the output layer 516 can be interpreted as the probability of the input data falling into one of the different categories.

In particular, convolutional neural networks 500 can be trained based on the backpropagation algorithm. For preventing overfitting, methods of regularization can be used, for example dropout of nodes 520, ..., 524, stochastic pooling, use of artificial data, weight decay based on the L1 or the L2 norm, or max norm constraints.

In the example of FIG 5, the MLM is a CNN, in particular, a convolutional neural network having a U-net structure. In the displayed example, the input data to the CNN is a two-dimensional medical image comprising 512x512 pixels, every pixel comprising one intensity value. The CNN comprises convolutional layers indicated by solid, horizontal arrows, pooling layers indicating by solid arrows pointing down, and upsampling layers indicated by solid arrows pointing up. The number of the respective nodes is indicated within the boxes. Within the U-net structure first the input images are downsampled, in particular by decreasing the size of the images and increasing the number of channels. Afterwards they are upsampled, in particular by increasing the size of the images and decreasing the number of channels, to generate a transformed image.

All except the last convolutional layers L1, L2, L4, L5, L7, L8, L10, L11, L13, L14, L16, L17, L19, L20 use 3x3 kernels with a padding of 1, the ReLU activation function, and a number of filters or convolutional kernels that matches the number of channels of the respective node layers as indicated in FIG 5. The last convolutional layer uses a 1x1 kernel with no padding and the ReLU activation function.

The pooling layers L3, L6, L9 are max-pooling layers, replacing four neighboring nodes with only one node, the value being the maximum of the values of the four neighboring nodes. The upsampling layers L12, L15, L18 are transposed convolution layers with 3x3 kernels and stride 2, which effectively quadruple the number of nodes. The dashed horizontal errors correspond to concatenation operations, where the output of a convolutional layer L2, L5, L8 of the downsampling branch of the U-net structure is used as additional inputs for a convolutional layer L13, L16, L19 of the upsampling branch of the U-net structure. This additional input data is treated as additional channels in the input node layer for the convolutional layer L13, L16, L19 of the upsampling branch.

Independent of the grammatical term usage, individuals with male, female or other gender identities are included within the term.

**Claims**

1.  Computer implemented method for image reconstruction in parallel magnetic resonance, MR, imaging, wherein

    - a respective set of regularly undersampled MR measurement data in k-space representing an imaged object (6) is received for each of a plurality of coil channels;
    - for each pair of coil channels of the plurality of coil channels, a respective set of reconstruction weights for reconstructing MR data at k-space points, which are not measured according to the undersampling, from the MR measurement data, is received;
    - for each of the plurality of coil channels, a respective coil sensitivity map is determined depending on the respective sets of reconstruction weights for the respective coil channel; and
    - a reconstructed MR image (23) is generated based on the coil sensitivity maps.

2.  Computer implemented method according to claim 1, wherein for each of the plurality of coil channels, the respective coil sensitivity map for a given voxel-position or pixel-position y of an aliased voxel or pixel, respectively, is determined as

$$C_I(y) = PI\left(\sum_J \chi_J^* \, W_{JI}(y)\right),$$

wherein I denotes the respective coil channel, J is an index running over all coil channels of the plurality of coil channels, $W_{JI}$ denotes a Fourier transform of the set of reconstruction weights for the respective pair of coil channels, $\chi_J$ denotes a predefined coil combination factor for the coil channel J, and PI(.) denotes respective pseudoinverses for matrices formed along indices according to the plurality of coil channels and sets of aliased voxel-positions or pixel-positions.

3. Computer implemented method according to one of the preceding claims, wherein the set of reconstruction weights is determined as a set of GRAPPA reconstruction weights or as a set of CAIPIRINHA reconstruction weights.

4. Computer implemented method according to one of claims 1 or 2, wherein

- the set of reconstruction weights is determined depending on pre-scan MR measurement data corresponding to a fully sampled k-space region; or
- the set of reconstruction weights is determined depending on a part of the MR measurement data corresponding to a fully sampled k-space region.

5. Computer implemented method according to one of the preceding claims, wherein

- a coil channel loss term is computed for each of the plurality of coil channels depending on a Fourier transformation of the set of MR measurement data for the respective coil channel and on the coil sensitivity maps; and
- the reconstruction comprises optimizing a first loss function, which depends on a sum of the coil channel loss terms.

6. Computer implemented method according to claim 5, wherein the coil channel terms for a given voxel-position or pixel-position y of an aliased voxel or pixel, respectively, are given by

$$\left\| D_I(y) - \sum_r \omega_r \, C_I(y + \delta_r) \, M(y + \delta_r) \right\|^2,$$

wherein I denotes the respective coil channel, $D_I$ denotes the Fourier transformation of the set of MR measurement data for the respective coil channel, M denotes the MR image to be reconstructed, r is an integer number in the interval [0, R[, wherein R is a predefined acceleration factor according to the undersampling, $\delta_r$ denotes a respective offset according to the undersampling, and $\omega_r$ denotes a superposition weight according to the undersampling.

7. Computer implemented method according to one of claims 5 or 6, wherein

- the reconstruction comprises, for each of at least two iterations,

a) receiving a prior MR image for the respective iteration;
b) generating an optimized MR image (21) by optimizing the first loss function based on the prior MR image; and
c) generating an enhanced MR image (22) by applying a trained machine learning model, MLM, for image enhancement to the optimized MR image (21);
d) the prior MR image of the respective iteration corresponds to the enhanced MR image (22) of a preceding iteration, unless the respective iteration corresponds to an initial iteration of the at least two iterations, and the prior MR image of the initial iteration corresponds to a predefined initial image (20); and

- the reconstructed MR image (23) corresponds to the enhanced MR image (22) of a final iteration of the at least two iterations.

8. Computer implemented method according to claim 7, wherein the optimization of the first loss function is carried out under variation of a variable MR image, while the prior MR image is kept constant during the optimization.

9. Computer implemented method according to claim 8, wherein the first loss function comprises a regularization term, which depends on the prior MR image and the variable MR image.

10. Computer implemented method according to claim 9, wherein the regularization term quantifies a deviation between the prior MR image and the variable MR image.

11. Computer implemented training method for training an MLM for image enhancement for use in a computer implemented method according to one of claims 7 to 10, wherein

- training MR data is received and a ground truth reconstructed MR image corresponding to the training MR data is received;
- for each training iteration of at least two training iterations,

a') a training prior MR image for the respective training iteration is received;
b') an optimized training MR image is generated by optimizing a predefined second loss function based on the training MR data and the training prior MR image;
c') an enhanced training MR image is generated by applying the MLM to the optimized training MR image;
d') the training prior MR image of the respective training iteration corresponds to the enhanced training MR image of a preceding training iteration, unless the respective training iteration corresponds to an initial training iteration of the at least two training iterations, and the training prior MR image of the initial training iteration corresponds to a predefined initial training image;

- a predefined third loss function is evaluated depending on the enhanced MR image of a final training iteration of the at least two training iterations and the ground truth MR image; and
- parameters of the MLM are updated depending on a result of the evaluation of the third loss function.

12. Computer implemented method according to one of claims 7 to 10, wherein the MLM is trained by using a computer implemented training according to claim 11.

13. Data processing apparatus comprising at least one computing unit (13, 14), which is adapted to carry out a computer implemented method according to one of claims 1 to 10 or 12 or a computer implemented training method according to claim 11.

14. System for MR imaging comprising

- a data processing apparatus according to claim 13, wherein the at least one computing unit (13, 14) is adapted to carry out a computer implemented method according to one of claims 1 to 10 or 12; and
- an MRI scanner (1), wherein the at least one computing unit (13, 14) is adapted to control the MRI scanner (1) to generate the set of MR measurement data.

15. Computer program product comprising instructions, which, when executed by a data processing apparatus, cause the data processing apparatus to carry out a computer implemented method according to one of claims 1 to 10 or 12 or a computer implemented training method according to claim 11.

FIG 1

FIG 2

```
┌─────┐     ┌─────┐     ┌─────┐     ┌─────┐
│ 200 │ ──► │ 220 │ ──► │ 240 │ ──► │ 260 │
└─────┘     └─────┘     └─────┘     └─────┘
```

FIG 3

```
        ┌─────┐
        │ 20  │
        └─────┘
┌─────┐   │   ┌─────┐      ◇      ┌─────┐      ◇     ┌─────┐
│ 300 │──►│──►│ 310 │───► 320 ───►│ 330 │───► 340 ──►│ 23  │
└─────┘       └─────┘             └─────┘            └─────┘
                │                   │
                ▼                   ▼
             ┌─────┐             ┌─────┐
             │ 21  │             │ 22  │
             └─────┘             └─────┘
```

FIG 4

```
┌─────┐     ┌─────┐     ┌─────┐     ┌─────┐
│ 400 │ ──► │ 420 │ ──► │ 440 │ ──► │ 460 │
└─────┘     └─────┘     └─────┘     └─────┘
```

FIG 5

FIG 6

| | Europäisches Patentamt European Patent Office Office européen des brevets | **PARTIAL EUROPEAN SEARCH REPORT** under Rule 62a and/or 63 of the European Patent Convention. This report shall be considered, for the purposes of subsequent proceedings, as the European search report | **Application Number** EP 24 15 1855 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | JONATHAN I TAMIR ET AL: "Unsupervised Deep Basis Pursuit: Learning Reconstruction without Ground-Truth Data", PROCEEDINGS OF THE INTERNATIONAL SOCIETY FOR MAGNETIC RESONANCE IN MEDICINE, 27TH ANNUAL MEETING AND EXHIBITION, MONTREAL, QC, CANADA, 11-16 MAY 2019, vol. 27, 660, 26 April 2019 (2019-04-26), XP040708047, * the whole document * | | INV. G01R33/56 G01R33/561 |
| T | DAVE VAN VEEN ET AL: "Using Untrained Convolutional Neural Networks to Accelerate MRI in 2D and 3D", PROCEEDINGS OF THE INTERNATIONAL SOCIETY FOR MAGNETIC RESONANCE IN MEDICINE, 29TH ANNUAL MEETING AND EXHIBITION, 15-20 MAY 2021, vol. 29, 1964, 30 April 2021 (2021-04-30), XP040723983, * the whole document * | | |

-/--

TECHNICAL FIELDS SEARCHED (IPC)

G01R

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 2 September 2024 | Raguin, Guy |

EPO FORM 1503 03.82 (P04E07)

page 1 of 2

Europäisches
Patentamt

European
Patent Office

Office européen
des brevets

**PARTIAL EUROPEAN SEARCH REPORT**

Application Number

EP 24 15 1855

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| A,D | ANAGHA DESHMANE ET AL: "Parallel MR imaging", JOURNAL OF MAGNETIC RESONANCE IMAGING, vol. 36, no. 1, 13 June 2012 (2012-06-13), pages 55-72, XP055546603, US ISSN: 1053-1807, DOI: 10.1002/jmri.23639 * the whole document * | 1-6, 13-15 | |
| A,D | FELIX A. BREUER ET AL: "Controlled aliasing in volumetric parallel imaging (2D CAIPIRINHA)", MAGNETIC RESONANCE IN MEDICINE, vol. 55, no. 3, 11 January 2006 (2006-01-11), pages 549-556, XP055133400, ISSN: 0740-3194, DOI: 10.1002/mrm.20787 * the whole document * | 1-6, 13-15 | TECHNICAL FIELDS SEARCHED (IPC) |
| A,D | GRISWOLD M A ET AL: "Generalized autocalibrating partially parallel acquisitions (GRAPPA)", MAGNETIC RESONANCE IN MEDICINE, WILEY-LISS, US, vol. 47, 1 June 2002 (2002-06-01), pages 1202-1210, XP002369548, ISSN: 0740-3194, DOI: 10.1002/MRM.10171 * the whole document * | 1-6, 13-15 | |
| A | US 2013/281822 A1 (GRAZIANI DOMINIC MICHAEL [US] ET AL) 24 October 2013 (2013-10-24) * the whole document * | 1-6, 13-15 | |

EPO FORM 1503 03.82 (P04C10)

Europäisches
Patentamt

European
Patent Office

Office européen
des brevets

**INCOMPLETE SEARCH
SHEET C**

**Application Number**

EP 24 15 1855

Claim(s) completely searchable:
    1-6

Claim(s) searched incompletely:
    13-15

Claim(s) not searched:
    7-12

Reason for the limitation of the search:

The reasons for which the application is considered not to comply with
the requirements of Art. 83 and 84 EPC to the extent that a meaningful
search regarding the state of the art on the basis of the subject-matter
of claims 7-12 (completely) and 13-15 (partially, when referring back to
any one of claims 7-12) is not possible (Rule 63(1) EPC) are specified in
the annexed opinion accompanying the partial European search report (EPO
Form 1703).

The search is carried out on the basis of the subject-matter of claims
1-6 and claims 13-15, when claims 13-15 refer back to any one of claims
1-6.

## ANNEX TO THE EUROPEAN SEARCH REPORT
## ON EUROPEAN PATENT APPLICATION NO.

EP 24 15 1855

This annex lists the patent family members relating to the patent documents cited in the above-mentioned European search report.
The members are as contained in the European Patent Office EDP file on
The European Patent Office is in no way liable for these particulars which are merely given for the purpose of information.

02-09-2024

| Patent document cited in search report | Publication date | Patent family member(s) | Publication date |
|---|---|---|---|
| US 2013281822 A1 | 24-10-2013 | NONE | |

EPO FORM P0459

For more details about this annex : see Official Journal of the European Patent Office, No. 12/82

## REFERENCES CITED IN THE DESCRIPTION

### Non-patent literature cited in the description

- **G. ZENG et al.** A review on deep learning MRI reconstruction without fully sampled k-space.. *BMC Med Imaging*, 2021, vol. 21, 195
- **O. RONNEBERGER et al.** U-Net: Convolutional Networks for Biomedical Image Segmentation. *arXiv:1505.04597v1*
- **M. A. GRISWOLD et al.** Generalized Autocalibrating Partially Parallel Acquisitions (GRAPPA). *Magn Reson Med.*, 2002, vol. 47, 1202-1210
- **F. A. BREUER et al.** Controlled Aliasing in Volumetric Parallel Imaging (2D CAIPIRINHA). *Magn Reson Med.*, 2006, vol. 55, 549-556
- **F. A. BREUER et al.** General Formulation for Quantitative G-factor Calculation in GRAPPA Reconstructions. *Magn Reson Med.*, 2009, vol. 62, 739-746
- **A. DESHMANE et al.** Parallel MR imaging.. *J Magn Reson Imaging*, 2012, vol. 36 (1), 55-72
- **K.P. PRUESSMANN et al.** SENSE: sensitivity encoding for fast MRI.. *Magn Reson Med.*, 04 November 1999, vol. 2 (5), 952-62
- **K.P. PRUESSMANN et al.** Advances in Sensitivity Encoding With Arbitrary k-Space Trajectories. *Magn Reson Med.*, 2001, vol. 46, 638-651
- **M. UECKER et al.** ESPIRiT - an eigenvalue approach to autocalibrating parallel MRI: where SENSE meets GRAPPA.. *Magn Reson Med.*, 07 March 2014, vol. 1 (3), 990-1001
- **F. A. BREUER et al.** *Controlled Aliasing ..*